(19) Europäisches Patentamt
European Patent Office
Office européen des brevets

(11) **EP 2 196 813 A2**

(12) **EUROPEAN PATENT APPLICATION**

(43) Date of publication:
**16.06.2010 Bulletin 2010/24**

(51) Int Cl.:
***G01R 31/36*** *(2006.01)*

(21) Application number: **09015141.6**

(22) Date of filing: **07.12.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **09.12.2008 JP 2008313353**

(71) Applicant: **Hitachi Ltd.**
**Chiyoda-ku**
**Tokyo 100-8280 (JP)**

(72) Inventor: **Honkura, Kohei**
**Tokyo 100-8220 (JP)**

(74) Representative: **Strehl Schübel-Hopf & Partner**
**Maximilianstrasse 54**
**80538 München (DE)**

(54) **Method and system for estimating life expectancy of secondary battery**

(57)     It is an object of the present invention to provide a technique for specifically estimating a life expectancy of a secondary battery.

The technique performs the steps of: determining an accumulating portion resistance of the secondary battery from an internal resistance thereof; determining an accumulating portion resistance increase coefficient under operating conditions of the secondary battery; and estimating a life expectancy of the secondary battery from the accumulating portion resistance and the accumulating portion resistance increase coefficient.

## FIG. 1

EP 2 196 813 A2

**Description**

BACKGROUND OF THE INVENTION

1. Field of the Invention

The present invention relates to a technique for estimating a life expectancy of a secondary battery.

2. Description of the Related Art

It is known that keeping a secondary battery (for example, a lithium secondary battery) under an unchanged condition of a high-temperature or deep charge depth, or subjecting the secondary battery to a charge-discharge cycle causes degradation thereof resulting in an increase in internal resistance. With increasing internal resistance, the output of the secondary battery decreases. In many cases, such an increase in internal resistance of the secondary battery is irreversible.

Rechargeable batteries have been applied to a wider range of applications in recent years. Accordingly, a technique for accurately estimating a life expectancy of a secondary battery is demanded. However, it is known that an increase coefficient of the internal resistance of the secondary battery depends on operating conditions (for example, storage temperature and storage voltage), and it is difficult to accurately estimate a life expectancy of the secondary battery. In conventional cases, therefore, a degradation state has determined by comparing the current-state internal resistance of the secondary battery with the initial-state internal resistance thereof.

JP-A-2002-340997 and JP-A-2001-292534 discuss a technique for determining a degradation state of a secondary battery. JP-A-2002-340997 discusses a technique for a lithium secondary battery, the technique comprising:

successively obtaining a battery voltage change value ($\Delta V$) in a predetermined time while performing constant-current charge and discharge; integrating pieces of time during which $\Delta V$ is equal to or less than a predetermined value; and calculating a degradation coefficient of the battery by using the obtained integrated time and the determination reference value. JP-A-2001-292534 discusses a technique for determining degradation of a secondary battery in a constant-current charge process by comparing an elapsed time ($\Delta t$) until the voltage reaches a predetermined level with a reference value or by comparing a voltage rise value ($\Delta V$) until a predetermined time elapses with a reference value. JP-A-2001-292534 also discusses a technique for determining degradation of a secondary battery in a constant-voltage charge process by comparing an elapsed time ($\Delta t$) until the current drops to a predetermined level with a reference value or by comparing a current drop value ($\Delta I$) until a predetermined time elapses with a reference value.

SUMMARY OF THE INVENTION

Conventional methods for evaluating a degradation state of a secondary battery evaluate its degradation level at the present time by comparing a relevant measured value with a reference value. However, these methods do not estimate a life expectancy of the secondary battery based on the obtained degradation level. Therefore, conventional methods have a problem that these can not be adopted for making a specific evaluation and judgment on a relation between operating environment and life expectancy.

The present invention is directed to providing a technique for specifically estimating a life expectancy of a secondary battery.

The present invention is a method for estimating a life expectancy of a secondary battery, the method comprising the steps of: obtaining current and voltage change values of the secondary battery; accepting operating condition parameters including an operating temperature and an operating voltage of the secondary battery; determining an internal resistance of the secondary battery from the obtained current and voltage change values; determining a resistance of an accumulating portion of the secondary battery from the determined internal resistance; determining a resistance increase coefficient of the accumulating portion in the accepted operating condition parameters; and estimating a life expectancy of the secondary battery from the resistance and the resistance increase coefficient of the accumulating portion.

BRIEF DESCRIPTION OF THE DRAWINGS

Other objects and advantages of the invention will become apparent from the following description of embodiments with reference to the accompanying drawings in which:

Fig. 1 is a schematic diagram of an overall configuration of a secondary battery;

Fig. 2 is a schematic diagram of an electrode facing portion of the secondary battery;

Fig. 3 is an equivalent circuit diagram of the electrode facing portion of the secondary battery;

Fig. 4 is a graph illustrating a result of a storage experiment using a storage temperature T and a storage voltage V as operating condition parameters;

Fig. 5 is an Arrenius plot of an accumulating portion resistance increase coefficient a;

Fig. 6 is a graph illustrating a relation between an intercept b and the storage voltage V of the Arrenius plot of Fig. 5;

Fig. 7 illustrates an overall configuration of the secondary battery life-expectancy estimation system according to the present embodiment;

Fig. 8 illustrates a hardware configuration of the secondary battery life-expectancy estimation unit;

Fig. 9 illustrates a functional configuration of the secondary battery life-expectancy estimation unit;

Fig. 10 illustrates processing for determining an internal resistance $R_1$;

Fig. 11 illustrates processing for determining an accumulating portion resistance $R_2$ and the accumulating portion resistance increase coefficient a; and

Fig. 12 illustrates processing for estimating a life expectancy of a secondary battery 400.

DESCRIPTION OF THE EMBODIMENTS

An embodiment according to the present invention will be described below with reference to the accompanying drawings. The embodiment describes a method for estimating a life expectancy of a lithium battery used as a secondary battery.

(Internal Resistance of Secondary battery 400)

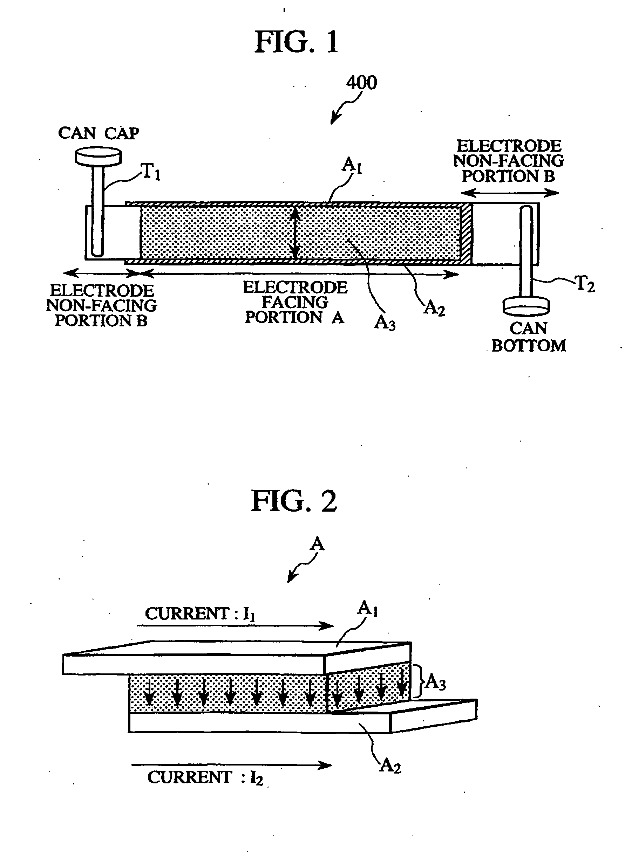

First, the internal resistance of the secondary battery 400 will be described below. The internal resistance R1 is determined by $\Delta V$ and $\Delta I$. As shown in Fig. 1, it can be assumed that the secondary battery 400 includes an electrode facing portion A at which a positive electrode and a negative electrode face each other and electrode non-facing portions B at which a positive electrode and a negative electrode do not face each other. An internal resistance $R_1$ of the secondary battery 400 can be represented by formula 1, where $R_3$ denotes the resistance of the electrode facing portion A and $R_4$ denotes the resistance of the electrode non-facing portions B.

Formula 1

$$R_1 = R_3 + R_4 \qquad \ldots\ldots (1)$$

The resistance $R_4$ of the electrode non-facing portions B is constant regardless of the degradation level of the secondary battery 400. Therefore, of components of the internal resistance $R_1$ of the secondary battery 400, the resistance $R_3$ of the electrode facing portion A causes an increase in the internal resistance $R_1$.

The resistance $R_3$ of the electrode facing portion A of the secondary battery 400 will be described below. Fig. 2 is a schematic diagram of the electrode facing portion A of the secondary battery 400. As shown in Fig. 2, the electrode facing portion A of the secondary battery 400 is composed of a positive-pole current collector $A_1$, a negative-pole current collector $A_2$, and an accumulating portion $A_3$.

When the accumulating portion $A_3$ has a resistance $R_2$, the positive-pole current collector $A_1$ has a resistance $R_5$, and the negative-pole current collector $A_2$ has a resistance $R_6$, the resistance $R_3$ of the electrode facing portion A is given by a function having these values as variables, $R_3$ ($R_2$, $R_5$, $R_6$). The resistance $R_5$ of the positive-pole current collector $A_1$ and the resistance $R_6$ of the negative-pole current collector $A_2$ are constant regardless of the degradation level of the secondary battery 400. Therefore, of components of the resistance $R_3$ of the electrode facing portion A of the secondary battery 400, the resistance $R_2$ of the accumulating portion $A_3$ causes an increase in the resistance $R_3$ of the electrode facing portion A. That is, the resistance $R_2$ of the accumulating portion $A_3$ (hereinafter referred to as accumulating portion resistance $R_2$) causes an increase in the internal resistance $R_1$.

Therefore, the present embodiment first determined the accumulating portion resistance $R_2$ out of components of the internal resistance $R_1$ of the secondary battery 400. Then, the present embodiment determined an increase coefficient a of the accumulating portion resistance $R_2$ (hereinafter referred to as accumulating portion resistance increase coefficient a) under the operating conditions of the secondary battery 400. Finally, the present embodiment estimates a life expectancy of the secondary battery 400 from the accumulating portion resistance $R_2$ and the accumulating portion resistance increase coefficient a.

(Determination of Storage Portion Resistance $R_2$)

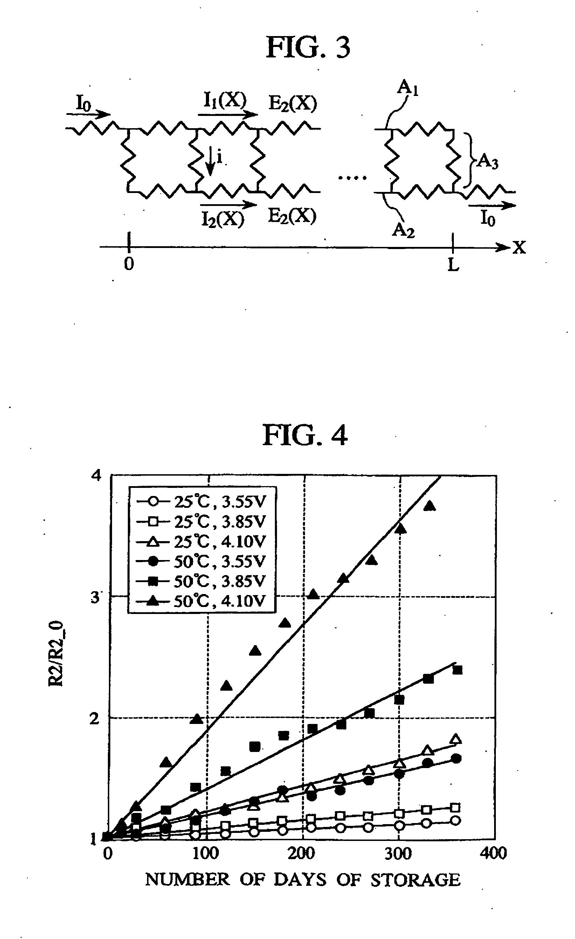

A method for determining the accumulating portion resistance $R_2$ will be described below. In order to determine the accumulating portion resistance $R_2$, the present embodiment assumes the electrode facing portion A of the secondary battery 400 as an equivalent circuit shown in Fig. 3.

Referring to Fig. 3, the electrode facing portion A has a longitudinal length L, one end of the accumulating portion $A_2$ on the side of a positive-pole current collecting tab $T_1$ is positioned at a position x=0, and the other end of the accumulating portion $A_2$ on the side of a negative-pole current collecting tab $T_2$ is positioned at a position x=L. This means that the x position of the electrode facing portion A ranges from 0 to L ($0 \leq x \leq L$).

Referring to Fig. 3, at a position x, the positive-pole current collector $A_1$ has an overvoltage $E_1(x)$ and a current flow $I_1(x)$, and the negative-pole current collector $A_2$ has an overvoltage $E_2(x)$ and a current flow $I_2(x)$. Each of external terminals of the secondary battery 400 has a current flow $I_0$.

Referring to Fig. 3, it is assumed that a current flows in the longitudinal direction (x direction) of the electrode facing portion A inside the positive-pole current collector $A_1$ and the negative-pole current collector $A_2$. It is also assumed that, at the accumulating portion $A_3$, a current flows in the thickness direction of the electrode facing portion A. In this case, the accumulating portion resistance $R_2$. is given by formula 2 where $r_2$ denotes a resistance per x-directional unit length of the accumulating portion $A_3$.

Formula 2

$$R_2 = \frac{r_2}{L} \qquad \qquad \ldots (2)$$

The resistance $R_5$ of the positive-pole current collector $A_1$ is given by formula 3 where $r_5$ denotes a resistance per x-directional unit length of the positive-pole current collector $A_1$.

Formula 3

$$R_5 = r_5 \cdot L \qquad \qquad \ldots (3)$$

Further, the resistance $R_6$ of the negative-pole current collector $A_2$, is given by formula 4 where $r_6$ denotes a resistance per x-directional unit length of the negative-pole current collector $A_2$.

Formula 4

$$R_6 = r_6 \cdot L \qquad \qquad \ldots (4)$$

where the resistance $r_5$ of the positive-pole current collector $A_1$ per x-directional unit length, and the resistance $r_6$ of the negative-pole current collector $A_2$ per x-directional unit length can be obtained from the volume resistivity of the material of the current collectors $A_1$ and $A_2$ and the cross-section area of the current collectors $A_1$ and $A_2$.

Further, since the total amount of the current $I_1$ flowing in the positive-pole current collector $A_1$ and the current $I_2$ flowing in the negative-pole current collector $A_2$ are constant, the following relation (formula 5) is given.

Formula 5

$$I_0 = I_1(x) + I_2(x) \qquad \cdots \cdots \ (5)$$

It can be assumed that the amount of decrease in the current $I_1$ flowing in the positive-pole current collector $A_1$ is equal to the amount of increase in the current $I_2$ flowing in the negative-pole current collector $A_2$. In other words, it can be assumed that the amount of decrease in the flowing current $I_1$ flowing in the positive-pole current collector $A_1$ is equal to the amount of a current flowing from the positive-pole current collector $A_1$ to the negative-pole current collector $A_2$ via the accumulating portion $A_3$.

Therefore, a relation among the current $I_1(x)$ flowing in the positive-pole current collector $A_1$ at the position x, the overvoltage $E_1(x)$ of the positive-pole current collector $A_1$ at the position x, and the overvoltage $E_2(x)$ of the negative-pole current collector $A_2$ at the position x can be represented by formula 6 where $r_2$ denotes the unit-length resistance of the accumulating portion $A_3$.

Formula 6

$$\frac{dI_1(x)}{dx} = -\frac{E_1(x) - E_2(x)}{r_2} \qquad \cdots \cdots \ (6)$$

Further, since a voltage drop value is given by the product of current and resistance, a change in the overvoltage $E_1$ of the positive-pole current collector $A_1$ at the position x can be represented by formula 7 where $I_1(x)$ denotes a current flowing in the positive-pole current collector $A_1$, and $r_5$ denotes the unit-length resistance of the positive-pole current collector $A_1$.

Formula 7

$$\frac{dE_1(x)}{dx} = -r_5 \cdot I_1(x) \qquad \cdots \cdots \ (7)$$

On the other hand, a change in the overvoltage $E_2(x)$ of the negative-pole current collector $A_2$ at the position x can be represented by formula 8 where $I_2(x)$ denotes a current flowing in the negative-pole current collector $A_2$, and $r_6$ denotes the unit-length resistance of the negative-pole current collector $A_2$.

Formula 8

$$\frac{dE_2(x)}{dx} = -r_6 \cdot I_2(x) \qquad \cdots \cdots (8)$$

Differential equations (6), (7), and (8) are solved to obtain $I_1(x)$, $I_2(x)$, $E_1(x)$, and $E_2(x)$ by using the following boundary conditions.

The following considers boundary conditions. When the secondary battery 400 is being charged, a current flows from the positive-pole current collector $A_1$ to the negative-pole current collector $A_2$. Therefore, at x=0, a current $I_1$ (0) flowing in the positive-pole current collector $A_1$ at x=0 is equal to an entire current $I_0$; at x=L, a current $I_1$(L) flowing in the positive-pole current collector $A_1$ is zero (boundary condition 1). Further, when $I_0$=0, both the overvoltage $E_1(x)$ of the positive-pole current collector $A_1$ and the overvoltage $E_2(x)$ of the positive-pole current collector $A_1$ are zero (boundary condition 2).

Based on the above-mentioned boundary conditions 1 and 2, differential equations (6), (7), and (8) are solved to obtain $I_1(x)$, $I_2(x)$, $E_1(x)$, and $E_2(x)$. When formulas 2, 3, and 4 are used, $I_1(x)$, $I_2(x)$, $E_1(x)$, and $E_2(x)$ can be represented as a function of $R_2$, $R_5$, and $R_6$.

Since the electrode facing portion A is connected to the positive pole at x=0 and to the negative pole at x=L, an observed overvoltage of the entire electrode facing portion A is given by formula 9.

Formula 9

$$E_1(0) - E_2(L) \qquad \cdots \cdots (9)$$

The resistance $R_3$ of the electrode facing portion A of the secondary battery 400 is obtained by dividing the overvoltage of the entire electrode facing portion A by the current $I_0$ flowing in the external terminals of the secondary battery 400. The resistance $R_3$ of the electrode facing portion A of the secondary battery 400 can be represented as a function of $R_2$, $R_5$, and $R_6$ (formula 10).

Formula 10

$$R_3 = \frac{R_5 \cdot R_6}{R_5 + R_6} + \frac{1}{x}\left\{\frac{R_5^2 + R_6^2}{R_5 + R_6}\coth(x) + \frac{2R_5 + R_6}{R_5 + R_6} \cdot \frac{1}{\sinh(x)}\right\}$$

$$\cdots \cdots (10)$$

x in formula 10 is given by formula 11.

Formula 11

$$x = \sqrt{\frac{R_5 + R_6}{R_2}} \qquad\qquad \ldots\ldots (11)$$

There is a relation, represented by formula 1, among the internal resistance $R_1$ of the secondary battery 400, the resistance $R_3$ of the electrode facing portion A, and the resistance $R_4$ of the electrode non-facing portions B. Therefore, assigning formulas 10 and 11 to formula 1 gives formula 12 which represents a relation between the internal resistance $R_1$ of the secondary battery 400 and the accumulating portion resistance $R_2$ (hereinafter formula 12 is referred to as a relational formula of $R_1$ and $R_2$).

Formula 12

$$R_1 = \frac{R_5 \cdot R_6}{R_5 + R_6} + \frac{1}{\sqrt{\frac{R_5 + R_6}{R_2}}} \left\{ \frac{R_5^2 + R_6^2}{R_5 + R_6} \coth\left(\sqrt{\frac{R_5 + R_6}{R_2}}\right) + \frac{2R_5 + R_6}{R_5 + R_6} \cdot \frac{1}{\sinh\left(\sqrt{\frac{R_5 + R_6}{R_2}}\right)} \right\} + R_4$$

$$\ldots\ldots (12)$$

In formula 12, the resistance $R_4$ of the electrode non-facing portions B, the resistance $R_5$ of the positive-pole current collector $A_1$, and the resistance $R_6$ of the negative-pole current collector $A_2$ are constant regardless of the degradation level of the secondary battery 400.
Therefore, with the resistance $R_4$ of the electrode non-facing portions B, the resistance $R_5$ of the positive-pole current collector $A_1$, and the resistance $R_6$ of the negative-pole current collector $A_2$ obtained in advance, assigning the internal resistance $R_1$ to formula 12 gives the accumulating portion resistance $R_2$.

In determining the accumulating portion resistance $R_2$, the present embodiment obtains the resistance $R_4$ of the electrode non-facing portions B, the resistance $R_5$ of the positive-pole current collector $A_1$, and the resistance $R_6$ of the negative-pole current collector $A_2$ in advance, and assigns these values to formula 12 for each type (type number) of the secondary battery 400. Specifically, the internal resistance $R_1$ is assigned to formula 12 corresponding to the type (type number) of the secondary battery 400 subjected to life expectancy estimation to determine the accumulating portion resistance $R_2$.

(Determination of Storage Portion Resistance Increase coefficient a)

A method for determining the accumulating portion resistance increase coefficient a under operating conditions of the secondary battery 400 will be described below. Since the accumulating portion resistance increase coefficient a depends on operating conditions (the storage temperature T and the storage voltage V), the accumulating portion resistance increase coefficient a can be represented by a function having the storage temperature T and the storage voltage V as variables, a(T,V). According to the present invention, a function of the accumulating portion resistance increase coefficient a, a(T,V), is obtained based on results of storage tests using different storage temperatures T and storage voltages V as parameters.

Fig. 4 is a graph illustrating results of storage tests actually performed by the inventor by using different storage temperatures T(=25, 50°C) and storage voltages V(=3.55, 3.85, 4.10V) as operating condition parameters.

Referring to Fig. 4, the vertical axis of Fig. 4 is assigned values which are obtained by dividing the accumulating portion resistance $R_2$ by an initial value $R_{2\_0}$ ($R_2/R_{2\_0}$), and the horizontal axis is assigned the number of days of storage.

The accumulating portion resistance $R_2$ is determined by assigning the internal resistance $R_1$ obtained during storage tests to the relational formula of $R_1$ and $R_2$ (formula 12) obtained by the above-mentioned method.

Referring to Fig. 4, when the relation between the values obtained by dividing the accumulating portion resistance $R_2$ by the initial value $R_{2\_0}$ ($R_2/R_{2\_0}$) and the number of days of storage in each storage environment is recognized as a linear function, a relation between the accumulating portion resistance $R_2$ and the accumulating portion resistance increase coefficient a (inclinations of measurement results of Fig. 4) can be represented by formula 13.

Formula 13

$$R_2 = R_{2\_0}(1 + at) \qquad \ldots\ldots (13)$$

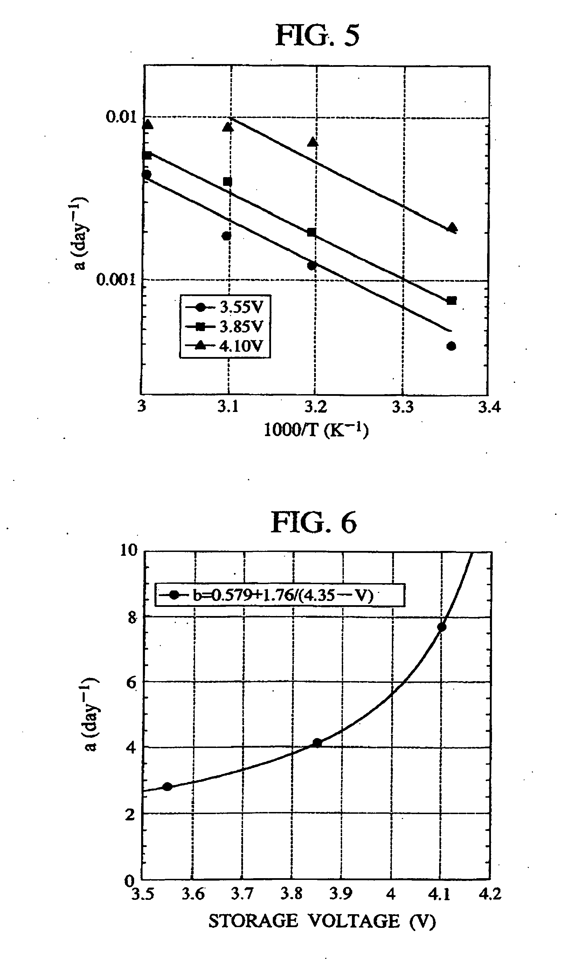

Fig. 5 is an Arrenius plot of the accumulating portion resistance increase coefficient a(T,V) given as an inclination of measurement result of Fig. 4. Fig. 5 illustrates that the accumulating portion resistance increase coefficient a has a linear behavior on the Arrenius plot under almost all operating conditions practically assumed (storage voltage V=3.55, 3.85, 4.10V). Fig. 5 also illustrates that the inclination of measurement result does not depend on the storage voltage V while an intercept of measurement result depends on the storage voltage V.

In consideration of the above, the function of the accumulating portion resistance increase coefficient a, a (T, V), can be represented by formula 14 where b and c are constants.

Formula 14

$$a(T, V) = b(V)\exp\left(-c/T\right) \qquad \ldots\ldots (14)$$

Fig. 6 is a graph illustrating a relation between an intercept b(V) and the storage voltage V in formula 14. In consideration of the relation between the intercept b(V) and the storage voltage V in Fig. 6, the intercept b(V) in formula 14 can be represented by formula 15 where d, e, and f are constants.

Formula 15

$$b(V) = b - e/(V - f) \qquad \ldots\ldots (15)$$

From formulas 14 and 15, the function of the accumulating portion resistance increase coefficient a, a(T,V), can be approximated to formula 16.

Formula 16

$$a(T,V) = [d - e/(V - f)]\exp(-c/T) \quad \ldots\ldots (16)$$

Assigning operating condition parameters (the operating temperature T and operating voltage V) to the function of this formula 16 gives the accumulating portion resistance increase coefficient a.

In determining the accumulating portion resistance increase coefficient a, the present embodiment performs storage tests by using different storage temperatures T and storage voltages V as operating condition parameters, and assigns constants c, d, e, and f obtained in advance to formula 16 for each type (type number) of the secondary battery 400. Specifically, the present embodiment assigns actual operating conditions (the storage temperature T and the storage voltage V) to formula 16 corresponding to the secondary battery 400 subjected to life expectancy estimation to determine the accumulating portion resistance increase coefficient a under actual operating conditions.

(Estimation of Life Expectancy)

A method for estimating a life expectancy of the secondary battery 400 will be described below. In the present embodiment, a maximum value of the accumulating portion resistance $R_2$, $R_{2\_max}$, is preset according to the secondary battery 400. Then, a point of time when the accumulating portion resistance $R_2$ reaches $R_{2\_max}$ is defined $t_{\_max}$ which represents a life expectancy of the secondary battery 400. The time when the internal resistance $R_1$ of the secondary battery 400 is determined is denoted as $t_{\_now}$, and the accumulating portion resistance $R_2$ at the time $t_{\_now}$ is denoted as $R_{2\_now}$.

The life expectancy of the secondary battery 400 can be denoted as $(t_{\_max}-t_{\_now})$. From formula 13, a relation between the life expectancy of the secondary battery 400 $(t_{\_max}-t_{\_now})$ and the accumulating portion resistances $R_2$ can be represented by formula 17.

Formula 17

$$R_{2\_max} - R_{2\_now} = R_{2\_0} \cdot a \cdot \left(t_{\_max} - t_{\_now}\right) \quad \ldots\ldots (17)$$

Assigning $R_{2\_now}$ which represents the accumulating portion resistance $R_2$ at the time $t_{\_now}$, and the accumulating portion resistance increase coefficient a obtained by the above-mentioned method to formula 17 gives the life expectancy of the secondary battery 400, $(t_{\_max}-t_{\_now})$.

In estimating a life expectancy, the present embodiment uses the relational formula 17 having a preset $R_{2\_max}$ which represents maximum value of the accumulating portion resistance $R_2$, for each type (type number) of the secondary battery 400. Specifically, the present embodiment assigns $R_{2\_now}$ which represents the accumulating portion resistance $R_2$ at the time $t_{\_now}$, and the accumulating portion resistance increase coefficient a to formula 17 corresponding to the type (type number) of secondary battery 400 subjected to life expectancy estimation to determine a life expectancy of the secondary battery 400, $(t_{\_max}-t_{\_now})$. The life expectancy $(t_{\_max}-t_{\_now})$ makes it possible to know a specific time when the secondary battery 400 comes to the end of its operating life, by using $t_{\_now}$ at which the internal resistance $R_1$ of the secondary battery 400 is determined.

The configuration of the secondary battery 400 and the principle for determining its life expectancy have specifically been described. Then, a secondary battery life-expectancy estimation system for estimating a life expectancy of the secondary battery 400 will be described below.

(Secondary battery Life-expectancy Estimation System)

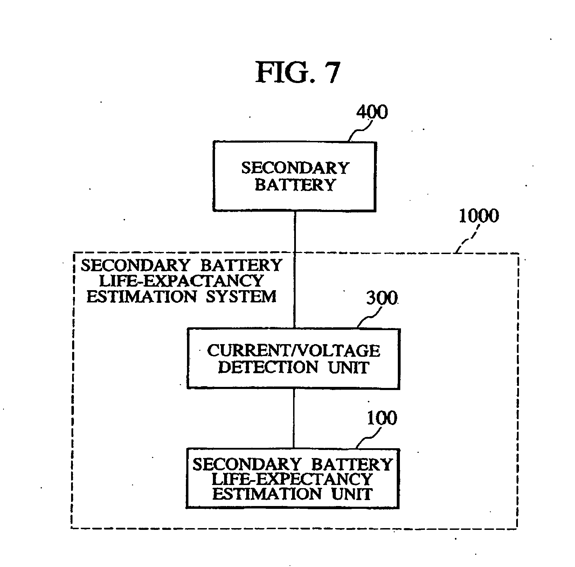

Fig. 7 illustrates an overall configuration of a secondary battery life-expectancy estimation system 1000 according to the present embodiment. The secondary battery life-expectancy estimation system according to the present embodiment includes a current/voltage detection unit 300 and a secondary battery life-expectancy estimation unit 100 which are attached to the secondary battery 400 subjected to life-expectancy estimation.

(Current/voltage Detection Unit 300)

Although not shown as a hardware system configuration, the current/voltage detection unit 300 includes connection terminal and cable to the secondary battery 400, a galvenostat, a voltmeter, a control unit, an input unit, an output unit, and an interface unit.

The current/voltage detection unit 300 is connected with the secondary battery life-expectancy estimation unit 100 via the interface unit. In this state, the current/voltage detection unit 300 is provided with a function for detecting a current change value $\Delta I$ and a voltage change value $\Delta V$ of the secondary battery 400 for calculating the internal resistance $R_1$ of the secondary battery 400. Specifically, the current/voltage detection unit 300 is provided with a function for sending any current $\Delta I$ to the secondary battery 400 via the galvenostat when it receives the "Current-and-voltage change values measurement command" from the secondary battery life-expectancy estimation unit 100. The current/voltage detection unit 300 is provided with a function for detecting, using a voltmeter, a voltage change $\Delta V$ caused by any current $\Delta I$ flowing in the secondary battery 400. Further, the current/voltage detection unit 300 is provided with a function for transmitting a current value (a current change value) $\Delta I$ sent to the secondary battery 400 as well as a voltage change $\Delta V$ of the secondary battery 400 to the secondary battery life-expectancy estimation unit 100.

The current/voltage detection unit 300 may (1) transmit a difference between a voltage immediately before any current $\Delta I$ flows in the secondary battery 400 and a voltage immediately after any current $\Delta I$ flows therein to the secondary battery life-expectancy estimation unit 100 as a voltage change $\Delta V$ of the secondary battery 400, or (2) transmit a difference between a voltage immediately before any current $\Delta I$ flows in the secondary battery 400 and a voltage after any time (for example, 5 seconds) have elapsed since any current $\Delta I$ flows therein to the secondary battery life-expectancy estimation unit 100 as a voltage change $\Delta V$ of the secondary battery 400.

(Secondary battery Life-expectancy Estimation Unit 100)

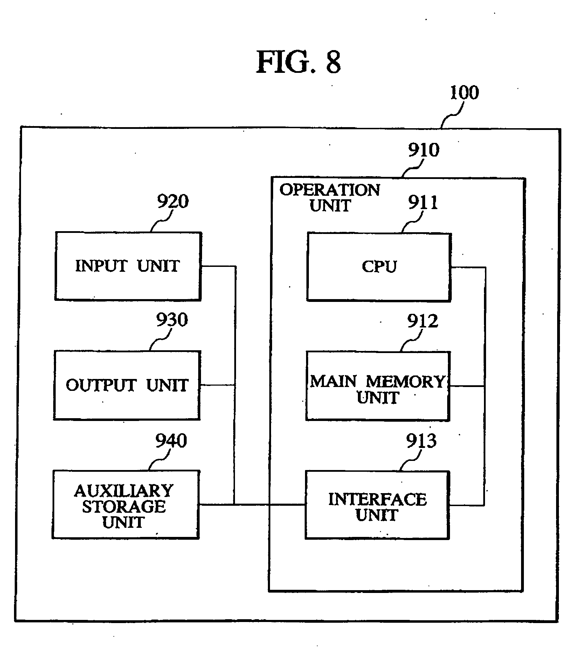

The secondary battery life-expectancy estimation unit 100 in the secondary battery life-expectancy estimation system according to the present embodiment will be described below. Fig. 8 illustrates a hardware configuration of the secondary battery life-expectancy estimation unit 100.

The secondary battery life-expectancy estimation unit 100 is attained by a computer which includes an operation unit 910, an input unit 920 such as a keyboard or a mouse, an output unit 930 such as a display unit, and an auxiliary storage unit 940 having, for example, a HDD. The operation unit 910 includes, for example, a central processing unit (CPU) 911, a main memory unit 912 such as random-access memory (RAM), and an interface unit 913 for communicating with the current/voltage detection unit 300, the input unit 920, the output unit 930, and the auxiliary storage unit 940, as shown in Fig. 8. The auxiliary storage unit 940 may further include a storage unit capable of reading a CD-ROM, a CD-RW, a DVD-ROM, and other a portable storage media.

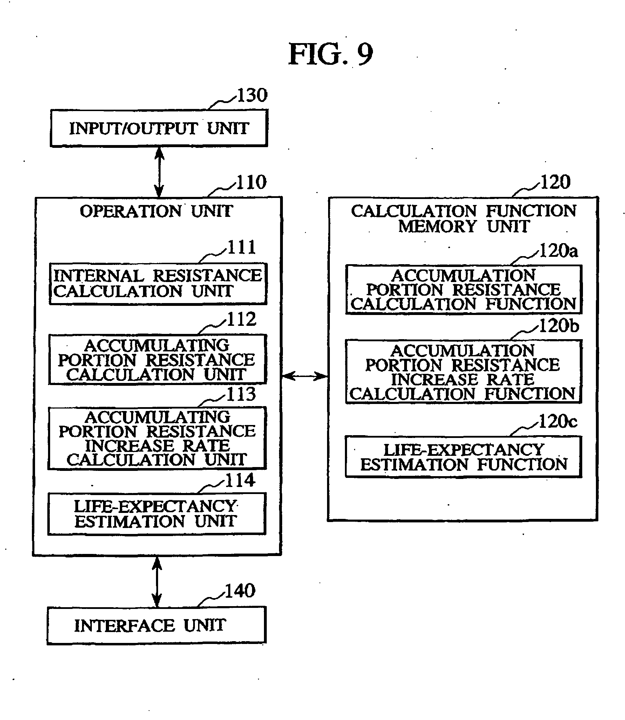

A functional configuration of the secondary battery life-expectancy estimation unit 100 according to the present embodiment will be described below. Fig. 9 illustrates the functional configuration of the secondary battery life-expectancy estimation unit 100 according to the present embodiment.

The life-expectancy estimation unit 100 according to the present embodiment includes an operation unit 110, a calculation function storage unit 120, an input/output unit 130, and an interface unit 140. The calculation function storage unit 120 shown in Fig. 9 can be attained, for example, by the auxiliary storage unit 940. The operation unit 110 shown in Fig. 9 is attained when the CPU 911 executes a predetermined program loaded from the auxiliary storage unit 940 into the main memory unit 912.

(Calculation Function Storage Unit 120)

The calculation function storage unit 120 stores the accumulating portion resistance calculation function 120a, the accumulating portion resistance increase coefficient calculation function 120b, and the life-expectancy estimation function 120c. The accumulating portion resistance calculation function 120a is required to calculate above-mentioned relational formula 12. Using the accumulating portion resistance calculation function 120a makes it possible to obtain the accumulating portion resistance $R_2$ from the internal resistance $R_1$. The accumulating portion resistance increase coefficient calculation function 120b is required to calculate above-mentioned relational formula 16. Using the accumulating portion resistance increase coefficient calculation function 120b makes it possible to obtain the accumulating portion resistance increase coefficient a. The life-expectancy estimation function 120c is required to calculate above-mentioned relational formula 17. The life-expectancy estimation function 120c makes it possible to obtain a life expectancy of the secondary battery 400.

(Operation Unit 110)

The operation unit 110 includes an internal resistance calculation unit 111, an accumulating portion resistance calculation unit 112, an accumulating portion resistance increase coefficient calculation unit 113, and a life-expectancy estimation unit 114, as shown in Fig. 9.

(Internal Resistance Calculation Unit 111)

The internal resistance calculation unit 111 attains a function for performing preprocess for calculating the internal resistance $R_1$ of the secondary battery 400, and a function for performing the calculation of the internal resistance $R_1$.

The function, of the internal resistance calculation unit 111, for performing preprocess firstly instructs the input/output unit 130 to display a user command acceptance screen. Secondly, the function for performing preprocess receives the "Life-expectancy estimation start command" from the user via the input unit 920. In this case, the function for performing preprocess accepts an input of numerical values of operating condition parameters (the operating temperature T and the operating voltage V) of the secondary battery 400 together with the "Life-expectancy estimation start command" via the input unit 920. As for input of numerical values of operating condition parameters, a guidance on the user command acceptance screen may be provided to support input. Thirdly, upon reception of the "Life-expectancy estimation start command", the function for performing preprocess transmits the "Current-and-voltage change values measurement command" to the current/voltage detection unit 300 via the interface unit 140. Fourthly, the function for performing preprocess receives a current change value $\Delta I$ and a voltage change value $\Delta V$ from the current/voltage detection unit 300, and holds the received current change value $\Delta I$ and the voltage change value $\Delta V$ in relation to the time $t_{\_now}$ of reception of these values.

Meanwhile, a calculation function in the internal resistance calculation unit 111 calculates the internal resistance $R_1$ of the secondary battery 400 from the held current change value $\Delta I$ and the voltage change value $\Delta V$.

(Accumulating Portion Resistance Calculation Unit 112)

The accumulating portion resistance calculation unit 112 is provided with a function for reading the accumulating portion resistance calculation function 121a from the calculation function storage unit 120, and a function for calculating the accumulating portion resistance $R_2$ by assigning the internal resistance $R_1$ of the secondary battery 400 calculated by the internal resistance calculation unit 111 to the accumulating portion resistance calculation function 121a read from the calculation function storage unit 120.

(Accumulating Portion Resistance Increase coefficient Calculation Unit 113)

The accumulating portion resistance increase coefficient calculation unit 113 is provided with a function for reading the accumulating portion resistance increase coefficient calculation function 120b from the calculation function storage unit 120, and a function for calculating the accumulating portion resistance increase coefficient a by assigning the operating condition parameters received on the user command acceptance screen to the accumulating portion resistance increase coefficient calculation function 120b read from the calculation function storage unit 120.

(Life-expectancy estimation unit 114)

The life-expectancy estimation unit 114 is provided with a function for reading the life-expectancy estimation function 120c from the calculation function storage unit 120, a function for estimating a life expectancy, and a function for instructing output of the estimated life expectancy. The function for estimating a life expectancy estimates a life expectancy of the secondary battery 400 by assigning the accumulating portion resistance $R_2$ calculated by the accumulating portion resistance calculation unit 112, the accumulating portion resistance increase coefficient a calculated by the accumulating portion resistance increase coefficient calculation unit 113, and the time when the current change value $\Delta I$ and the voltage change value $\Delta V$ are accepted to the life-expectancy estimation function 120c read from the calculation function storage unit 120. In estimating a life expectancy, the present embodiment assumes that the time $t_{\_now}$ when the internal resistance $R_1$ of the secondary battery 400 is calculated in the life-expectancy estimation function 120c (formula 17) is the time of reception of the current change value ΔI and the voltage change value ΔV.

The function for instructing output of the life expectancy instructs the input/output unit 130 to display the estimated life expectancy of the secondary battery 400. The function can also instruct the input/output unit 130 to display a specific time when the secondary battery 400 comes to the end of its operating life by using $t_{now}$.

(Input/output Unit 130)

The input/output unit 130 is provided with a function for displaying the user command acceptance screen and output the estimated life expectancy of the secondary battery 400, that is, a function for accepting a display command and outputting the life expectancy to the output unit 930 such as a display unit. The input/output unit 130 is provided with a function for accepting the "Life-expectancy estimation start command" and operating condition parameters of the secondary battery 400 from the user via the input unit 920 by following the user command acceptance screen.

(Interface Unit 140)

The interface unit 140 performs information exchange between the secondary battery life-expectancy estimation unit 100 and the current/voltage detection unit 300.

(Processing)

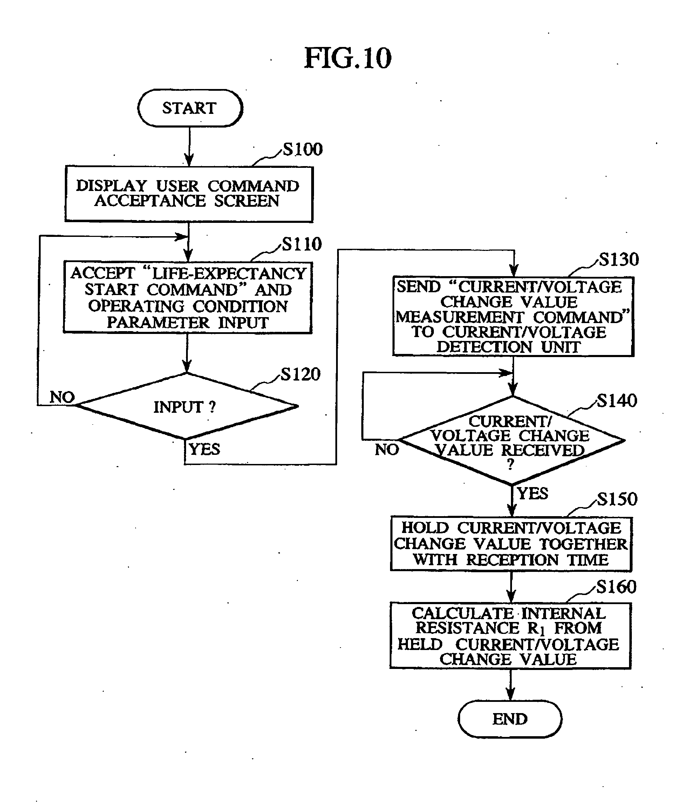

Processing in the secondary battery life-expectancy estimation system according to the present embodiment will be described below with reference to Figs. 10 to 12.

(Processing for Calculating Internal Resistance $R_1$)

Processing for calculating the internal resistance $R_1$ in the secondary battery life-expectancy estimation unit 100 according to the present embodiment will be described below. Fig. 10 illustrates processing for calculating the internal resistance $R_1$.

First, a function for performing preprocess in the internal resistance calculation unit 111 operates. Specifically, in step S100, the internal resistance calculation unit 111 instructs the input/output unit 130 to display the user command acceptance screen.

In step S110, the function for performing preprocess in the internal resistance calculation unit 111 accepts the "Life-expectancy estimation start command" and input of numerical values of operating condition parameters from the user via the input unit 920. In step S130, when the function accepts input of numerical value of operating condition parameter from the user (YES in step S120), the function for performing preprocess in the internal resistance calculation unit 111 transmits the "Current-and-voltage change values measurement command" to the current/voltage detection unit 300 via the interface unit 140 from the user. Otherwise, when the function accepts no inputs of numerical value of operating condition parameter from the user (NO in step S120), processing returns to step S110 to accept input of operating condition parameters from the user.

After transmitting the "Current-and-voltage change values measurement command" to the current/voltage detection unit 300, in step S140, the function for performing preprocess in the internal resistance calculation unit 111 waits for reception of current and voltage change values from the current/voltage detection unit 300. When the function receives current and voltage change values from the current/voltage detection unit 300 (YES in step S140), in step S150, the function holds the received current and voltage change values together with the time of reception of these values. Otherwise, when the function receives no current and voltage change values (NO in step S140), the function waits for reception of current and voltage change values from the current/voltage detection unit 300.

In step S160, the calculation function in the internal resistance calculation unit 111 calculates the internal resistance $R_1$ of the secondary battery 400 from the held current change value ΔI and voltage change value ΔV held in step S150.

(Processing for Calculating Accumulating Portion Resistance $R_2$ and Accumulating Portion Resistance Increase coefficient a)

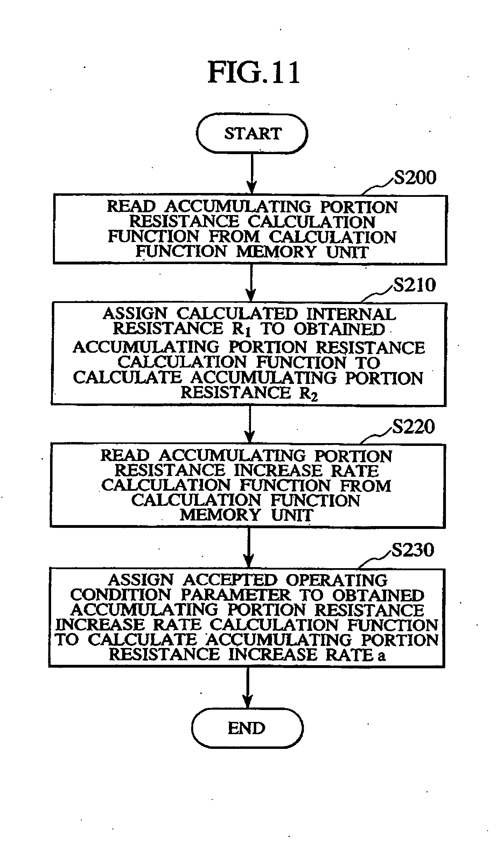

Processing for calculating the accumulating portion resistance $R_2$ and the accumulating portion resistance increase coefficient a in the secondary battery life-expectancy estimation unit 100 according to the present embodiment will be described below. Fig. 11 illustrates processing for calculating the accumulating portion resistance $R_2$ and the accumulating portion resistance increase coefficient a.

First, in step S200, the accumulating portion resistance calculation unit 112 serves as a function read-out function to read the accumulating portion resistance calculation function 121a from the calculation function storage unit 120. In step S210, the accumulating portion resistance calculation unit 112 calculates the accumulating portion resistance $R_2$ by assigning the internal resistance $R_1$ calculated by the internal resistance calculation unit 111 to the accumulating portion resistance calculation function 121a read from the calculation function storage unit 120.

In step S220, the accumulating portion resistance increase coefficient calculation unit 113 serves as a function read-out function to read the accumulating portion resistance increase coefficient calculation function 121b from the calculation function storage unit 120. In step S230, the accumulating portion resistance increase coefficient calculation unit 113 calculates the accumulating portion resistance increase coefficient a by assigning the operating condition parameters of the secondary battery 400 received from the user command acceptance screen to the accumulating portion resistance increase coefficient calculation function 121b read from the calculation function storage unit 120.

(Processing for Estimating Life Expectancy of Secondary battery)

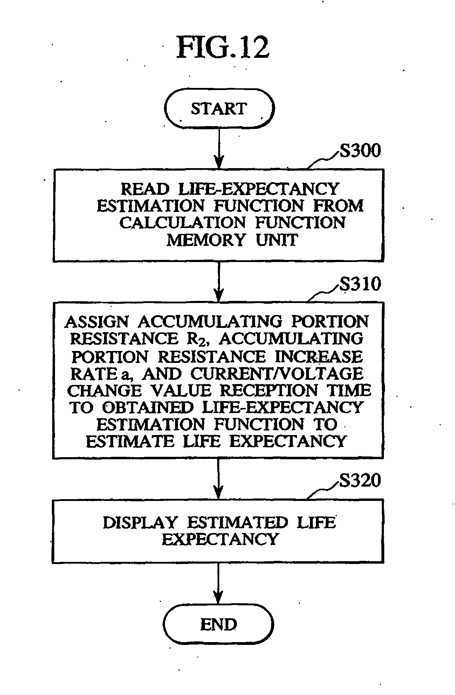

Then, processing for estimating a life expectancy of the secondary battery 400 in the secondary battery life-expectancy estimation unit 100 according to the present embodiment will be described below. Fig. 12 illustrates processing for estimating a life expectancy of the secondary battery 400.

First, in step S300, the life-expectancy estimation unit 114 serves as a function read-out function to read the life-expectancy estimation function 120c from the calculation function storage unit 120. Subsequently, in step S310, the life-expectancy estimation unit 114 serves as an operation function for estimating a life expectancy by assigning the accumulating portion resistance $R_2$ calculated by the accumulating portion resistance calculation unit 112, the accumulating portion resistance increase coefficient a calculated by the accumulating portion resistance increase coefficient calculation unit 113, and the time $t_{\_now}$ of reception of current and voltage change values to the life-expectancy estimation function 120c read from the calculation function storage unit 120. In estimating a life expectancy, the present embodiment assumes that the time $t_{\_now}$ when the internal resistance $R_1$ of the secondary battery 400 is calculated in the life-expectancy estimation function 120c (formula 17) is the time of reception of the current change value $\Delta I$ and the voltage change value $\Delta V$.

In step S320, the life-expectancy estimation unit 114 instructs the input/output unit 130 to display the life expectancy of the secondary battery 400. The life-expectancy estimation unit 114 may instruct the input/output unit 130 to display a specific time when the secondary battery 400 comes to the end of its operating life by using $t_{\_now}$.

As described above, the present embodiment can specifically estimate a life expectancy of the secondary battery 400. Further, control of operating conditions of the secondary battery can make the life expectancy of the secondary battery increase or decrease based on a result of life expectancy estimation according to the present invention.

Further important aspects of the secondary battery life-expectancy estimation system of the invention reside in the following:

the life expectancy estimating means comprises a storage means for prestoring determining function for estimate a life expectancy of the secondary battery, and a life expectancy calculating means for executing said determining function;

the internal resistance determining means performs processes for accepting a life-expectancy estimation start command for instructing start of life expectancy estimation; receiving current and voltage change values from a current/voltage detection; and determining an internal resistance from the held current and voltage change values;

the accumulating portion resistance determining means performs the processes for reading the accumulating portion resistance determining function from a storage unit; and determining an accumulating portion resistance by assigning said internal resistance to said accumulating portion resistance determining function;

the increase coefficient determining means performs the processes for reading the accumulating portion resistance increase coefficient determining function from a storage unit; and determining an accumulating portion resistance increase coefficient by assigning operating condition parameters to the read accumulating portion resistance increase coefficient determining function;

the life expectancy estimating means performs the processes for reading the life-expectancy estimation function from a storage unit; estimating a life expectancy by assigning the accumulating portion resistance and the increase coefficient to the read life-expectancy estimation function.

While the invention has been described in its preferred embodiments, it is to be understood that the words which have been used are words of description rather than limitation and that changes within the purview of the appended claims may be made without departing from the true scope and spirit of the invention in its broader aspects.

**Claims**

1. A method for estimating a life expectancy of a secondary battery, comprising;
   determining an internal resistance(R1) of the secondary battery from variations in current and voltage (ΔV,ΔI) ;
   determining an accumulating portion resistance (R2) of the secondary battery from the internal resistance (R1) ;
   determining an increase coefficient (a) of said accumulating portion resistance (R2) from condition parameters including an operating voltage(V) and a surrounding temperature(T) of the secondary battery; and estimating a life expectancy of the secondary battery from the accumulating portion resistance (R2) and the increase coefficient (a).

2. The method of claim 1,
   wherein the life expectancy is calculated from a time when variations in current and voltage are obtained.

3. The method of claim 1,
   wherein the secondary battery is a lithium secondary battery.

4. The method of claim 1,
   wherein said estimating said life expectancy is based on the following formula :

$$R_{2\_max} - R_{2\_now} = R_{2\_0} \cdot a \cdot \left( t_{\_max} - t_{\_now} \right)$$

Wherein R2 is said accumulating portion resistance, $R_{2\_max}$ is a maximum value of the accumulating portion resistance $R_2$,
$t_{\_max}$ is a time when the accumulating portion resistance $R_2$ reaches $R_{2\_max}$,
$t_{\_now}$ is a time when the internal resistance $R_1$ is determined,
$R_{2\_now}$ is a accumulating portion resistance $R_2$ at the time $t_{\_now}$,
a is a increase coefficient of accumulating portion resistance,
$R_{2\_0}$ is an initial value of accumulating portion resistance $R_2$.

5. The method of claim 1,
   wherein said determining an accumulating portion resistance (R2) is based on the following formula :

$$R_1 = \frac{R_5 \cdot R_6}{R_5 + R_6} + \frac{1}{\sqrt{\frac{R_5 + R_6}{R_2}}} \left\{ \frac{R_5^2 + R_6^2}{R_5 + R_6} \coth \left( \sqrt{\frac{R_5 + R_6}{R_2}} \right) + \frac{2R_5 + R_6}{R_5 + R_6} \cdot \frac{1}{\sinh \left( \sqrt{\frac{R_5 + R_6}{R_2}} \right)} \right\} + R_4$$

wherein $R_4$ is a resistance of electrode non-facing portions of said secondary battery,
$R_5$ is a resistance of a positive-pole current collector of said secondary battery,
$R_6$ is a resistance of a negative-pole current collector of said secondary battery,
and wherein $R_4$, $R_5$, and $R_6$ are design parameters of said secondary battery.
(and wherein $R_4$, $R_5$, and $R_6$ are determined prior to estimating said life expectancy)

6. The method of claim 1,
   wherein determining said internal resistance of the secondary battery is based on resistance of non-facing portions electrode and current collectors.

7. An apparatus for estimating a life expectancy of a secondary battery, comprising:

   an input/output unit;
   an operation unit;
   a storage unit; and

an interface unit;
wherein said operation unit further comprising;
an internal resistance determining unit;
an accumulating portion resistance determining unit;
an increase coefficient of accumulating portion resistance determining unit; and
a life-expectancy estimation unit;
wherein said increase coefficient determining unit configured to determine an increase coefficient of accumulating portion resistance by assigning operating condition parameters including an operating temperature and an operating voltage of the secondary battery;
and
wherein said life-expectancy estimation unit configured to estimate a life expectancy of the secondary battery using said accumulating portion resistance and said increase coefficient of accumulating portion resistance.

8. The apparatus of claim 7, wherein said storage unit prestores

an accumulating portion resistance determining function configured to determine an accumulating portion resistance of the secondary battery by assigning an internal resistance of the secondary battery;
an increase coefficient determining function configured to determine an increase coefficient of accumulating portion resistance by assigning operating condition parameters including an operating temperature and an operating voltage of the secondary battery; and
a life-expectancy estimation function configured to estimate a life expectancy of the secondary battery using the accumulating portion resistance and the accumulating portion resistance increase coefficient.

9. The apparatus of claim 8, wherein the internal resistance determining unit performs processes for:

accepting a life-expectancy estimation start command for instructing a start of life expectancy estimation and the operating condition parameters from a user via the input/output unit;
receiving current and voltage change values via the interface unit, and holding the current and voltage change values together with the time of reception of these values; and
determining an internal resistance from the held current and voltage change values,

wherein the accumulating portion resistance determining unit performs the steps of:

reading the accumulating portion resistance determining function from the storage unit; and
determining an accumulating portion resistance by assigning the internal resistance determined by the internal resistance determining unit to the read accumulating portion resistance determining function.

10. The apparatus of claim 8, wherein the increase coefficient determining unit performs processes for:

reading the increase coefficient determining function from the storage unit; and
determining an increase coefficient of accumulating portion resistance by assigning the operating condition parameters received by the internal resistance determining unit to the read increase coefficient determining function.

11. The apparatus of claim 8, wherein the life-expectancy estimation unit performs processes for:

reading the life-expectancy estimation function from the storage unit; and
executing the life-expectancy function to estimate a life expectancy of the secondary battery by assigning the accumulating portion resistance determined by the accumulating portion resistance determining unit and the increase coefficient determined by the increase coefficient determining unit.

12. The apparatus of claim 7, wherein the life-expectancy estimation unit determines a time when the secondary battery comes to the end of its operating life by using a time when the internal resistance determining unit received the current and voltage change values.

13. A secondary battery life-expectancy estimation system for estimating a life expectancy of a secondary battery, comprising:

a current/voltage detection unit attached to the secondary battery; and

a secondary battery life-expectancy estimation apparatus according to claim 7.

**14.** The secondary battery life-expectancy estimation system of claim 13, wherein the current/voltage detection unit performs the processes for:

receiving current and voltage change values measurement command from the secondary battery life-expectancy estimation unit; and measuring the current and voltage change values of the secondary battery and transmitting these values to the secondary battery life-expectancy estimation unit.

**15.** A secondary battery life-expectancy estimation system for estimating a life expectancy of a secondary battery, comprising:

an internal resistance(R1) determining means for determining an internal resistance(R1) of the secondary battery from variations in current and voltage $(\Delta V, \Delta I)$ ;
an accumulating portion resistance (R2) determining means for determining an accumulating portion resistance (R2) of the secondary battery from the internal resistance (R1) ; an increase coefficient (a) determining means for determining an increase coefficient (a) of said accumulating portion resistance (R2) from condition parameters including an operating voltage(V) and a surrounding temperature(T) of the secondary battery; and
a life expectancy estimating means for estimating a life expectancy of the secondary battery from the accumulating portion resistance(R2) and the increase coefficient (a).

# FIG. 1

# FIG. 2

# FIG. 3

$I_0$ $I_1(X)$ $E_2(X)$ $A_1$

$\downarrow i$ .... $A_3$

$I_2(X)$ $E_2(X)$ $A_2$ $I_0$

$\longrightarrow X$

0 L

# FIG. 4

NUMBER OF DAYS OF STORAGE

Legend:
- 25℃, 3.55V
- 25℃, 3.85V
- 25℃, 4.10V
- 50℃, 3.55V
- 50℃, 3.85V
- 50℃, 4.10V

R2/R2_0

## FIG. 5

## FIG. 6

# FIG. 7

400

```
SECONDARY
BATTERY
```

1000

SECONDARY BATTERY
LIFE-EXPACTANCY
ESTIMATION SYSTEM

300

```
CURRENT/VOLTAGE
DETECTION UNIT
```

100

```
SECONDARY BATTERY
LIFE-EXPECTANCY
ESTIMATION UNIT
```

# FIG. 8

100

910

920

OPERATION
UNIT          911

| INPUT UNIT |

| CPU |

930

912

| OUTPUT UNIT |

| MAIN MEMORY
UNIT |

940

913

| AUXILIARY
STORAGE
UNIT |

| INTERFACE
UNIT |

# FIG. 9

```
            ┌─────────────────────────────┐ ~130
            │      INPUT/OUTPUT UNIT       │
            └─────────────────────────────┘
                          ↕
~110                                          ~120
┌──────────────────────────┐    ┌──────────────────────────────┐
│     OPERATION UNIT        │    │   CALCULATION FUNCTION       │
│                           │    │       MEMORY UNIT            │
│                    ~111   │    │                      ~120a   │
│ ┌───────────────────────┐ │    │ ┌──────────────────────────┐ │
│ │ INTERNAL RESISTANCE   │ │    │ │      ACCUMULATION        │ │
│ │ CALCULATION UNIT      │ │    │ │  PORTION RESISTANCE      │ │
│ └───────────────────────┘ │    │ │  CALCULATION FUNCTION    │ │
│                    ~112   │    │ └──────────────────────────┘ │
│ ┌───────────────────────┐ │    │                      ~120b   │
│ │    ACCUMULATING       │ │    │ ┌──────────────────────────┐ │
│ │ PORTION RESISTANCE    │ │◄──►│ │      ACCUMULATION        │ │
│ │ CALCULATION UNIT      │ │    │ │  PORTION RESISTANCE      │ │
│ └───────────────────────┘ │    │ │     INCREASE RATE        │ │
│                    ~113   │    │ │  CALCULATION FUNCTION    │ │
│ ┌───────────────────────┐ │    │ └──────────────────────────┘ │
│ │    ACCUMULATING       │ │    │                      ~120c   │
│ │ PORTION RESISTANCE    │ │    │ ┌──────────────────────────┐ │
│ │    INCREASE RATE      │ │    │ │    LIFE-EXPECTANCY       │ │
│ │ CALCULATION UNIT      │ │    │ │  ESTIMATION FUNCTION     │ │
│ └───────────────────────┘ │    │ └──────────────────────────┘ │
│                    ~114   │    └──────────────────────────────┘
│ ┌───────────────────────┐ │
│ │   LIFE-EXPECTANCY     │ │
│ │  ESTIMATION UNIT      │ │
│ └───────────────────────┘ │
└──────────────────────────┘
            ↕
            ~140
┌─────────────────────────────┐
│      INTERFACE UNIT          │
└─────────────────────────────┘
```

# FIG.10

START

S100
DISPLAY USER COMMAND
ACCEPTANCE SCREEN

S110
ACCEPT "LIFE-EXPECTANCY
START COMMAND" AND
OPERATING CONDITION
PARAMETER INPUT

S120
NO — INPUT ?
YES

S130
SEND "CURRENT/VOLTAGE
CHANGE VALUE
MEASUREMENT COMMAND"
TO CURRENT/VOLTAGE
DETECTION UNIT

S140
NO — CURRENT/
VOLTAGE CHANGE
VALUE RECEIVED
?
YES

S150
HOLD CURRENT/VOLTAGE
CHANGE VALUE TOGETHER
WITH RECEPTION TIME

S160
CALCULATE INTERNAL
RESISTANCE $R_1$ FROM
HELD CURRENT/VOLTAGE
CHANGE VALUE

END

# FIG.11

```
START
```

$\downarrow$ S200

```
READ ACCUMULATING PORTION
RESISTANCE CALCULATION
FUNCTION FROM CALCULATION
FUNCTION MEMORY UNIT
```

$\downarrow$ S210

```
ASSIGN CALCULATED INTERNAL
RESISTANCE R₁ TO OBTAINED
ACCUMULATING PORTION RESISTANCE
CALCULATION FUNCTION TO
CALCULATE ACCUMULATING PORTION
RESISTANCE R₂
```

$\downarrow$ S220

```
READ ACCUMULATING PORTION
RESISTANCE INCREASE RATE
CALCULATION FUNCTION FROM
CALCULATION FUNCTION
MEMORY UNIT
```

$\downarrow$ S230

```
ASSIGN ACCEPTED OPERATING
CONDITION PARAMETER TO OBTAINED
ACCUMULATING PORTION RESISTANCE
INCREASE RATE CALCULATION FUNCTION
TO CALCULATE ACCUMULATING PORTION
RESISTANCE INCREASE RATE a
```

$\downarrow$

```
END
```

# FIG.12

START

S300

READ LIFE-EXPECTANCY
ESTIMATION FUNCTION FROM
CALCULATION FUNCTION
MEMORY UNIT

S310

ASSIGN ACCUMULATING PORTION
RESISTANCE $R_2$, ACCUMULATING
PORTION RESISTANCE INCREASE
RATE a, AND CURRENT/VOLTAGE
CHANGE VALUE RECEPTION TIME
TO OBTAINED LIFE-EXPECTANCY
ESTIMATION FUNCTION TO
ESTIMATE LIFE EXPECTANCY

S320

DISPLAY ESTIMATED LIFE
EXPECTANCY

END

## REFERENCES CITED IN THE DESCRIPTION

**Patent documents cited in the description**

- JP 2002340997 A
- JP 2001292534 A